# EUROPEAN PATENT SPECIFICATION

(11) **EP 0 540 117 B1**
(45) Date of publication and mention of the grant of the patent: **15.01.1997**
(21) Application number: 92203315.4
(22) Date of filing: 28.10.1992
(51) Int. Cl.: H03M 1/14

(54) **Multistep analog-to-digital converter with error correction**
Mehrschritt-Analog-Digital-Umsetzer mit Fehlerkorrektur
Convertisseur analogique-numérique à plusieurs pas à correction d'erreurs

(30) Priority: 01.11.1991 EP 91202845
(43) Date of publication of application: 05.05.1993
(73) Proprietor: Philips Electronics N.V., 5621 BA Eindhoven (NL)
(72) Inventor: Vorenkamp, Pieter, c/o INT. OCTROOIBUREAU B.V., NL-5656 AA Eindhoven (NL); Verdaasdonk, J.P.M., c/o INT. OCTROOIBUREAU B.V., NL-5656 AA Eindhoven (NL); Pelgrom, M.J.M., c/o INT. OCTROOIBUREAU B.V., NL-5656 AA Eindhoven (NL)
(74) Representative: Schoonheijm, Harry Barend

(56) References cited:
- US-A- 3 891 984
- US-A- 3 967 269

## Description

The invention relates to an analog-to-digital converter comprising:
- a first analog-to-digital converter for converting a first analog signal to a first digital signal which denotes in what sub-range of a plurality of sub-ranges the first analog signal is situated,
- a digital-to-analog converter converting the first digital signal to a second analog signal,
- a second analog-to-digital converter for converting a difference signal indicative of the difference between the first and second analog signals to a second digital signal,
- detection means for detecting an overflow and an underflow if the difference signal is situated above and below respectively, the sub-range denoted by the first digital signal,
- correction means for correcting the first digital signal in response to the detection of the overflow and underflow.

An analog-to-digital converter (ADC) of this type is known from United States Patent No. 3,967,269 and is of a type known as multistep or sub-ranging ADC. In this type of ADC the conversion to the desired digital output signal is performed in two or more steps while in each step a separate ADC converts an ever smaller sub-range of the overall range of the analog input signal to be converted. In the prior art ADC, a coarse conversion of the first analog signal to be converted to the first digital signal is effected in the first ADC 1 having an M-bit resolution. The first digital signal is reconverted to a second analog signal in the digital-to-analog converter. The difference between the second and first analog signals is then fine-converted to the second digital signal by means of the second ADC having an (N-M)-bit resolution. The M bits of the first and the (N-M) bits of the second digital signal are combined to the desired N-bit digital output signal, the bits of the first digital signal forming the most significant bits and the bits of the second digital signal forming the least significant bits of the output signal.

As a result of errors in the system the difference signal may come to be outside the analog sub-range determined by the first ADC. Such errors may be caused by, for example, decision errors in the first ADC. The prior art ADC comprises detection means signalling by means of an overflow signal or an underflow signal whether the difference signal has come to be above or below the sub-range as a result of an error. In the prior art ADC the error is corrected in the following manner. In the case of an overflow the second ADC produces a second digital signal which has a value reduced by a number equal to the maximum number of sub-ranges the second ADC is capable of measuring (fold-back) and in a digital arithmetic unit one bit is subtracted from the first digital signal. In the case of an underflow the second ADC produces a second digital signal which has a value increased by afore-mentioned number and in the digital arithmetic unit one bit is subtracted from the first digital signal. If neither an underflow nor an overflow is detected, the difference signal lies within the range denoted by the first digital signal. In that case the second digital signal is produced by the second ADC unaltered, and no arithmetic operation is performed on the first digital signal by the digital arithmetic unit.

A disadvantage of this prior art error correction method is that the digital arithmetic unit is to be capable of both adding one bit to the first digital signal and subtracting one bit therefrom. The realisation of an arithmetic unit which is capable of performing both operations is circumstantial.

It is an object of the invention to provide a multistep ADC with an error correction that is simpler to implement.

An analog-to-digital converter of the type mentioned in the opening paragraph is characterized according to the invention, in that the correction means comprise:
- generating means for generating a third digital signal which represents a value that is one least significant bit lower than the value represented by the first digital signal,
- adder means for adding to the third digital signal zero and two least significant bits respectively, in the case of a detection of the underflow and overflow respectively, and one least significant bit in the other case.

The third digital signal always has a value one least significant bit lower than the first digital signal. For the error correction a mere addition by zero, one or two least significant bits to the third digital signal is now sufficient. When underflow is detected, nothing is added to the third digital signal, when overflow is detected, two bits are added and if the difference signal lies within the range, one bit is added to the third digital signal. The result of these operations on the first digital signal has the same effect as that of a one-bit adding/subtracting operation according to the state of the art.

The invention will now be further explained with reference to the appended drawing, in which:
Fig. 1 shows a block diagram of an analog-to-digital converter according to the invention;
Fig. 2 shows a diagram in explanation of the operation of the analog-to-digital converter shown in Fig. 1; and
Fig. 3 shows a circuit diagram of a correction circuit to be used in the analog-to-digital converter shown in Fig. 1.

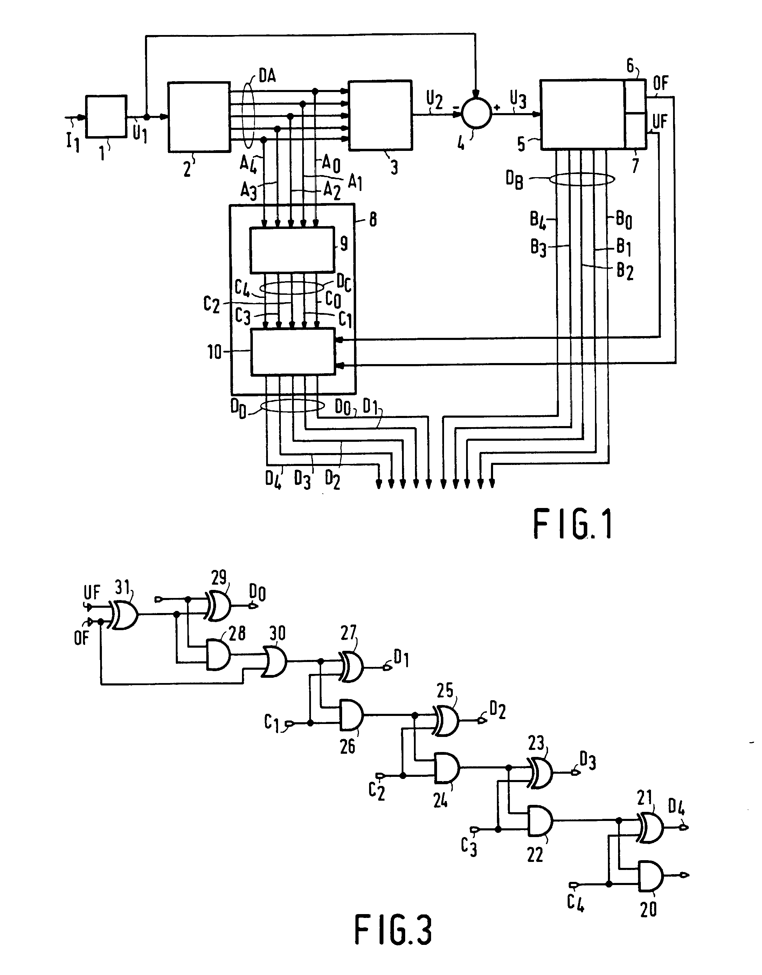

Fig. 1 shows a two-step sub-ranging analog-to-digital converter (ADC) with error correction according to the invention. An analog signal to be converted I₁ is applied *via* a sample-and-hold circuit 1 as a sampled analog signal U₁ to a first ADC 2. This ADC 2 performs a coarse conversion of the analog signal U₁ and produces a first digital signal D_{A} with a resolution selected to be, for example, 5 bits, of which the least significant bit (LSB) is referenced A₀ and the most significant bit (MSB) is referenced A₄. The digital signal D_{A} is reconverted in a digital-to-analog converter (DAC) 3 to a second analog signal U₂ which marks the beginning of the analog sub-range of the input signal U₁ determined by the coarse ADC 2. Coarse ADC 2 in this example divides the overall range of the input signal U₁ into 2⁵=32 sub-ranges. In a difference stage 4 the second analog signal U₂ is subtracted from the first analog signal U₁. The conversion in coarse ADC 2 takes some time. The sample-and-hold circuit 1 provides that the analog signals applied to the difference stage 4 and to the coarse ADC 2 have the same instantaneous value. The difference signal U₃ between the analog signals U₁ and U₂ is applied to a second ADC 5 and converted to a second digital signal D_{B} likewise containing 5 bits, of which the MSB is referenced B₄ and the LSB is referenced B₀. ADC 5 performs a fine conversion of the difference signal U₃ and divides the sub-range selected by coarse ADC 2 into 32 smaller sub-ranges. In this fashion a total of 32 x 32 = 1024 (2¹⁰) sub-ranges are distinguished in the amplitude range of the analog signal U₁. The ADCs 2 and 5 may be of any known type, for example, flash converters comprising a resistance ladder and comparators.

When an errorless coarse conversion is performed by coarse ADC 2, the difference signal U₃ will always be situated in the same analog signal range that is covered by fine ADC 5. However, if through unknown causes coarse ADC 2 produces a digital signal D_{A} that does not correspond to the actual sub-range in which the analog signal U₁ is situated, the difference signal U₃ will fall outside the expected range and the digital output signal D_{B} of fine ADC 5 will present an incorrect value. For this matter, the digital signal D_{B} cannot be smaller than 00000 and not be greater than 11111. To eliminate this situation, fine ADC 5 comprises an overflow detector 6 which produces an overflow bit OF that signals, for example, by means of OF = 1, when the difference signal U₃ is greater than permitted and includes an underflow detector 7 which produces an underflow bit UF that signals, by means of UF = 1, that the difference signal is smaller than permitted. The OF and UF bits may be generated in various ways, for example, by permitting fine ADC 5 converting twice as large a signal range as is strictly necessary. Internally, the fine ADC 5 then operates with a resolution of one bit more, in this case 6 bits.

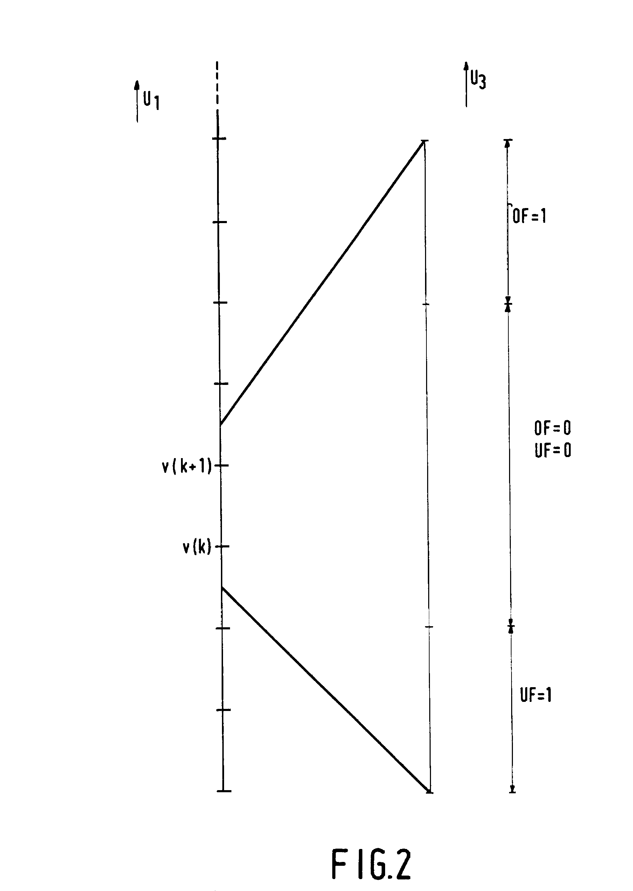

Fig. 2 shows how the range of the analog signal U₁ is divided into sub-ranges by the coarse ADC 2. Only a few sub-ranges of all the 32 have been shown. The signal range U₃ of fine ADC 5 is twice as large as the sub-range V(K+1)-V(K) of the coarse ADC 2 determined by two successive reference values, and overlaps this sub-range by equally large portions on either side. The operation of the fine ADC 5 may be as described in afore-mentioned United States Patent No. 3,967,269. If the analog signal U₁ exceeds V(K+1), there is an overflow situation and the underflow detector 7 generates an overflow bit OF=1. The 6-bit internal number is reduced by 2⁵+2⁴=48 (fold-back) and the 5 least significant bits of the resulting number are presented on the output of the fine ADC 5. If the analog signal U₁ is smaller than V(K), there is an underflow situation and the underflow detector 7 generates an underflow bit UF = 1. The 6-bit internal number is now increased by 2⁴ = 16 and only the 5 least significant bits of the resulting number are presented on the output of the fine ADC 5. If the analog signal U₁ lies between the reference values V(K+ 1) and V(K), both the overflow bit OF=0 and the underflow bit UF=0. The difference signal U₃ is then in range. The 6-bit internal number is reduced by 2⁴=16 and 5 least significant bits thereof are presented on the output of the fine ADC 5.

The correction of the digital signal D_{A} of the coarse ADC 2 is effected in the correction means 8 in response to the overflow bit OF and underflow bit UF. In a decoder 9 the digital signal D_{A} is first decoded to a third digital signal D_{C} with the bits C₄-C₀ and having a value that is one LSB lower than the value of the digital signal D_{A}. Subsequently, the digital signal D_{C} is processed in an adder 10 and the result of this operation becomes available on an output as a digital signal D_{D} with the bits D₄-D₀. In adder 10 nothing is added to the digital signal D_{C} if the underflow bit UF=1; 1 LSB is added if both the overflow bit OF=0 and the underflow bit UF=0 and 2 LSBs are added if the overflow bit OF=1. Thus, a detected incorrect value of the digital signal D_{A} from the coarse ADC 2 is corrected in the correction means 8 by way of arithmetical operations which are either a subtraction or an addition and are therefore relatively simple to implement.

The decoder 9 may form part of the coarse ADC 2 which produces in that case both the digital signal D_{A} and the digital signal D_{C}. This is especially advantageous if ADC 2 operates with an internal digital code, such as, for example, the thermometer code which differs from the digital code presented on the output terminals. ADC 2 then internally comprises a decoder which converts the internal thermometer code to the desired digital output signal code. It is then relatively simple to modify this decoder which is present anyway and give it a twofold function, so that in addition to the digital signal D_{A} also the digital signal D_{C} is produced.

A further possibility is that DAC 3 is arranged for receiving a digital signal having a code equal to the internal code, for example, again the thermometer code of ADC 2. In that case no decoding of the internal thermometer code to the desired output signal code is necessary in ADC 2. The decoder in ADC 2 then only performs the single function of decoder 9.

Furthermore, it is also possible for the adder 10 to be incorporated in the coarse ADC 2 and this ADC to have two outputs: one for the normal digital signal D_{A} and one for the digital signal D_{D}.

The bits of the digital signals D_{D} and D_{B} together form the digital output signal of the two-step ADC. The 5 bits D₄-D₀ of D_{D} form the most significant bits and the 5 bits B₄-B₀ of D_{B} form the least significant bits of the 10-bit output signal.

Fig. 3 shows a possible realisation of the adder 10. Bit C₄ of the digital signal D_{C} is fed to an input of both the dual input AND gate 20 and a dual input X-OR gate 21. Bits C₃, C₂, C₁ and C₀ are similarly fed to the respective AND gate 22 and X-OR gate 23, AND gate 24 and X-OR gate 25, AND gate 26 and X-OR gate 27, and AND gate 28 and X-OR gate 29. The remaining inputs of the gates 20 and 21 are connected to the output of the gate 22. The remaining inputs of the gates 22 and 23 and the gates 24 and 25 are similarly connected to the outputs of the respective gates 24 and 26. The remaining inputs of the gates 26 and 27 are connected to the output of a dual-input OR gate 30, whose one input is connected to the output of gate 28 and whose other input is connected to the overflow bit OF. The overflow bit OF and the underflow bit UF are fed to inputs of a dual input X-OR gate 31 whose output is connected to the remaining inputs of the gates 28 and 29. On the outputs of the gates 21, 23, 25, 27 and 29 are available the bits D₄, D₃, D₂, D₁ and D₀. The output of gate 20 presents a carry-bit.

The invention is not restricted to the depicted two times 5-bit two-step analog-to-digital converter. The error correction may also be used in multistep converters having any desired resolution.

## Claims

1. Analog-to-digital converter comprising:
- a first analog-to-digital converter (2) for converting a first analog signal (U₁) to a first digital signal (D_{A}) which denotes in what sub-range from a plurality of sub-ranges the first analog signal (U₁) is situated,
- a digital-to-analog converter (3) converting the first digital signal (D_{A}) to a second analog signal (U₂),
- a second analog-to-digital converter (5) for converting a difference signal (U₃) indicative of the difference between the first and second analog signals (U₁, U₂) to a second digital signal (D_{B}),
- detection means (6,7) for detecting an overflow (OF) and an underflow (UF) if the difference signal is situated above and below respectively, the sub-range denoted by the first digital signal,
- correction means (8) for correcting the first digital signal (D_{A}) in response to the detection of the overflow (OF) and underflow (UF), characterized in that the correction means (8) comprise:
- generating means (9) for generating a third digital signal (D_{C}) which represents a value that is one least significant bit less than the value represented by the first digital signal (D_{A}),
- adder means (10) for adding to the third digital signal (D_{C}) zero and two least significant bits respectively, in the case of a detection of the underflow (UF) and overflow (OF) respectively, and one least significant bit in the other case.

2. Analog-to-digital converter as claimed in Claim 1, characterized in that the first analog-to-digital converter (2) comprises a decoder for decoding an internal digital signal having an internal code to the first digital signal (D_{A}) having an external code which differs from the internal code, and in that the generating means (9) for generating the third digital signal (D_{C}) are included in the decoder.

3. Analog-to-digital converter as claimed in Claim 2, characterized in that the external code of the first digital signal (D_{A}) is equal to the internal code of the first analog-to-digital converter (2) and in that the digital-to-analog converter (3) is arranged for receiving a digital input signal having the internal code.

## Patentansprüche

1. Analog-Digital-Wandler mit:
- einem ersten Analog-Digital-Wandler (2) zum Umwandeln eines ersten analogen Signals (U₁) in ein erstes digitales Signal (D_{A}), was angibt, in welchem Teilbereich einer Anzahl Teilbereiche das erste analoge Signal (U₁) liegt,
- einem Digital-Analog-Wandler (3), der das erste digitale Signal (D_{A}) in ein zweites analoges Signal (U₂) umwandelt,
- einem zweiten Analog-Digital-Wandler (5) zum Umwandeln eines Differenzsignals U₃), das kennzeichnend ist für die Differenz zwischen dem ersten und dem zweiten analogen Signal (U₁, U₂) in ein zweites digitales Signal (D_{B}),
- Detektionsmitteln (6, 7) zum Detektieren eines Überflusses (OF) und eines Unterflusses (UF), wenn das Differenzsignal über bzw. unter dem durch das erste digitale Signal bezeichneten Teilbereich liegt,
- Korrekturmitteln (8) zum Korrigieren des ersten digitalen Signals (D_{A}) in Antwort auf die Detektion des Überflusses (OF) und Unterflusses (UF), dadurch gekennzeichnet, daß die Korrekturmittel (8) die nachfolgenden Elemente aufweisen:
- Erzeugungsmittel (9) zum Erzeugen eines dritten digitalen Signals (D_{C}), das einen Wert darstellt, der um ein am wenigsten signifikantes Bit niedriger ist als der durch das erste digitale Signal (D_{A}) dargestellte Wert,
- Addiermittel (10) zum Addieren von Null und von zwei am wenigsten signifikanten Bits zu dem dritten digitalen Signal (D_{C}) im Falle einer Detektion des Unterflusses (UF) bzw. Überflusses (OF) und von einem am wenigsten signifikanten Bit im anderen Fall.

2. Analog-Digital-Wandler nach Anspruch 1, dadurch gekennzeichnet, daß der erste Analog-Digital-Wandler (2) einen Decoder aufweist zum Decodieren eines inneren digitalen Signals mit einem inneren Code in das erste digitale Signal (D_{A}) mit einem äußeren Code, der von dem inneren Code abweicht, und daß die Erzeugungsmittel (9) zum Erzeugen des dritten digitalen Signals (D_{C}) in dem Decoder vorgesehen sind.

3. Analog-Digital-Wandler nach Anspruch 2. dadurch gekennzeichnet, daß der äußere Code des ersten digitalen Signals (D_{A}) dem inneren Code des Analog-Digital-Wandlers (2) entspricht und daß der Digital-Analog-Wandler (3) zum Erzeugen eines digitalen Eingangssignals mit dem inneren Code vorgesehen ist.

## Revendications

1. Convertisseur analogique/numérique comportant:
- un premier convertisseur analogique/numérique (2) pour convertir un premier signal analogique (U₁) en un premier signal numérique (D_{A}) indiquant dans quelle sous-gamme d'une pluralité de sous-gammes se situe le premier signal analogique (U₁),
- un convertisseur numérique/analogique (3) convertissant le premier signal numérique (D_{A}) en un deuxième signal analogique (U₂),
- un deuxième convertisseur analogique/numérique (5) pour convertir un signal différentiel (U₃) indicatif de la différence présente entre les premier et deuxième signaux analogiques (U₁, U₂) en un deuxième signal numérique (D_{B}),
- des moyens de détection (6, 7) pour détecter un dépassement de capacité supérieur (OF) et un dépassement de capacité inférieur (UF) si le signal différentiel se situe au-dessus respectivement au-dessous de la sous-gamme indiquée par le premier signal numérique,
- des moyens de correction (8) pour corriger le premier signal numérique (D_{A}) en réaction à la détection du dépassement de capacité supérieur (OF) et du dépassement de capacité inférieur (UF), caractérisé en ce que les moyens de correction (8) comportent:
- des moyens d'engendrement (9) pour engendrer un troisième signal numérique (D_{C}) représentant une valeur qui est plus faible d'un bit le moins significatif que la valeur représentée par le premier signal numérique (D_{A}),
- des moyens d'addition (10) pour additionner au troisième signal numérique (D_{C}) zéro respectivement deux bits les moins significatifs dans le cas d'une détection du dépassement de capacité inférieur (UF) respectivement du dépassement de capacité supérieur (OF) et un bit le moins significatif dans l'autre cas.

2. Convertisseur analogique/numérique selon la revendication 1, caractérisé en ce que le premier convertisseur analogique/numérique (2) comporte un décodeur pour décoder un signal numérique interne présentant un code interne en le premier signal numérique (D_{A}) présentant un code externe qui diffère du code interne et en ce que les moyens d'engendrement (9) pour engendrer le troisième signal numérique (D_{C}) sont incorporés dans le décodeur.

3. Convertisseur analogique/numérique selon la revendication 2, caractérisé en ce que le code externe du premier signal numérique (D_{A}) est égal au code interne du premier convertisseur analogique/numérique (2) et en ce que le convertisseur numérique/analogique (3) est disposé de manière à recevoir un signal d'entrée numérique présentant le code interne.
